# EUROPÄISCHE PATENTANMELDUNG

(11) **EP 4 184 530 A1**
(43) Veröffentlichungstag der Anmeldung: **24.05.2023**
(21) Anmeldenummer: 22208322.2
(22) Anmeldetag: 18.11.2022
(51) Int. Cl.: H01B 7/04, H01B 7/08, H05K 1/03

(54) **KABELSATZ SOWIE VERFAHREN ZUR HERSTELLUNG EINES KABELSATZES**

(30) Priorität: 23.11.2021 DE 102021213198
(71) Anmelder: LEONI Bordnetz-Systeme GmbH, 97318 Kitzingen (DE)
(72) Erfinder: SCHNEIDER, Bernd, 97337 Dettelbach (DE); RAU, Markus, 97318 Kitzingen (DE)
(74) Vertreter: FDST Patentanwälte

(57) **Zusammenfassung**

Der Kabelsatz (2) dient zur elektrischen Verbindung von zwei Komponenten und weist erfindungsgemäß eine Flachleitung (8) mit mehreren von einer Isolierung umgebene Leiter (4) auf, wobei die Leiter (4) zwischen zwei Isolierlagen (6) einlaminiert sind. Bei den Leitern (4) handelt es sich insbesondere um Rundleiter und die Flachleitung (8) ist weiterhin vorzugsweise in einen Hauptstrang (24) sowie in zumindest einen Nebenstrang (26) unterteilt zur Ausbildung einer Abzweigleitung (22). Hierdurch ist eine kostengünstige und automatisierte Fertigung eines auch verzweigten Kabelsatzes (2) ermöglicht.

## Beschreibung

Die Erfindung betrifft einen Kabelsatz zur elektrischen Verbindung von zumindest zwei Komponenten mithilfe einer Flachleitung, die mehrere von einer Isolierung umgebene Leiter in einer flachen Anordnung aufweist. Die Erfindung betrifft weiterhin ein Verfahren zur Herstellung eines derartigen Kabelsatzes.

Unter Kabelsatz wird vorliegend insbesondere ein verzweigter Kabelsatz verstanden, welcher einen Hauptstrang sowie ein oder mehrere hiervon abzweigende Nebenstränge aufweist, welche Abzweigleitungen bilden.

Kabelsätze werden unter anderem in der Automobilindustrie eingesetzt, bei der es insbesondere auf eine gewichts- und raumoptimierte Gestaltung bei gleichzeitig geringen Kosten ankommt.

Herkömmliche Kabelsätze bestehen häufig aus einer Vielzahl von einzelnen Leitungen oder Adern, die manuell zu einem runden Bündel zusammengefasst und beispielsweise mit einer Bandierung versehen werden. Derartige Kabelsätze sind jedoch in der Regel sehr biegeschlaff und eignen sich weniger für eine automatisierte Verlegung, die im Rahmen von nachhaltigen und kostengünstigen Herstellungsverfahren angestrebt wird.

Für automatisierte Verfahren ist grundsätzlich die Verwendung von Flachleitungen bekannt, bei denen mehrere Leiter nebeneinander angeordnet sind. Aus der US 4 200 929 A ist es beispielsweise bekannt, zur Ausbildung einer Flachleitung die einzelnen Leiter mithilfe eines Extrusionsprozesses mit einer Isolierung zu versehen.

Häufig werden bei Flachleitungen flachgewalzte Leiter eingesetzt. Weiterhin ist die Verwendung von gedruckten Schaltungen bekannt (FPC: Flexible Printed Circuit), bei denen die Leiterstrukturen additiv oder subtraktiv durch bekannte Techniken der Leiterplatten-Herstellung erzeugt werden.

Ausgehend hiervon liegt der Erfindung die Aufgabe zugrunde, eine kostengünstige und einfache Herstellung eines Kabelsatzes zu ermöglichen, welcher sich insbesondere auch automatisiert herstellen sowie montieren lässt.

Die Aufgabe wird gemäß der Erfindung gelöst durch einen Kabelsatz, welcher eine Flachleitung aufweist, welche mehrere von einer Isolierung umgebene Leiter umfasst, die zwischen zwei Isolierlagen einlaminiert sind.

Der Kabelsatz dient allgemein zur elektrischen Verbindung von zwei oder mehr Komponenten. Der Kabelsatz wird insbesondere in einem Kraftfahrzeug eingesetzt. Bei dem Kabelsatz handelt es sich typischerweise um einen verzweigten Kabelsatz mit ein oder mehreren von einem Hauptstrang abzweigenden Abzweigleitungen, wie er eingangs definiert wurde. Bei dem Kabelsatz sind die insbesondere als blanke, unisolierte Leiter ausgeführten Leiter in einer Ebene nebeneinander angeordnet und unmittelbar zwischen den zwei Isolierlagen im Rahmen eines Laminierprozesses einlaminiert. Die Leiter bilden mit den Isolierlagen einen Laminatverbund aus. Die beiden Isolierlagen bilden dabei die Isolierung aus. Die beiden Isolierlagen sind allgemein stoffschlüssig miteinander verbunden, beispielsweise miteinander verklebt oder miteinander verschweißt. Bevorzugt sind die beiden Isolierlagen dabei sowohl randseitig als auch in den Zwischenbereichen zwischen den Leitern miteinander stoffschlüssig verbunden

Ein derartiger Laminierprozess ist im Vergleich zu einem bekannten Extrusionsprozess zur Ausbildung der Flachleitung deutlich einfacher und schneller und damit auch kostengünstiger, insbesondere, da vorgefertigte Isolierlagen herangezogen werden können.

Bei dem Laminierprozess wird insbesondere derart vorgegangen, dass in einem kontinuierlichen Prozess die einzelnen Leiter parallel zueinander gemeinsam mit den beiden Isolierlagen und zwischen diesen zugeführt werden, wobei anschließend, z.B. durch Walzen die beiden Isolierlagen mit den dazwischen angeordneten Leitern gegeneinander gepresst und stoffschlüssig miteinander verbunden werden, so dass der Laminatverbund ausgebildet wird.

Bei den Isolierlagen handelt sich allgemein um flache Isolierbänder aus einem geeigneten Isolierwerkstoff, beispielsweise aus einem thermoplastischen Kunststoff, insbesondere aus PP.

Die Leiter liegen unmittelbar an den beiden Isolierlagen an, d.h. es sind keine weiteren Zwischenlagen, bevorzugt auch nicht bereichsweise, angeordnet. Beim Herstellen werden die einzelnen Leiter direkt zwischen den beiden Isolierlagen angeordnet. Zwischen den beiden Isolierlagen sind bevorzugt auch keine sonstigen weiteren Elemente, wie z.B. Elektronikbauteile, angeordnet. Der Laminatverbund besteht daher bevorzugt abschließend aus den vorzugsweise blanken Leitern und den beiden Isolierlagen.

Aufgrund des beschriebenen Herstellungsprozesses, bei dem die Leiter parallel zugeführt werden, erstrecken sich die Leiter im Laminatverbund beispielsweise über dessen gesamte Länge durchgehend geradlinig und parallel zueinander. Es besteht die Möglichkeit, dass Abschnitte des gesamten Laminatverbundes umgeklappt werden, so dass in diesem Fall die Leiter in den verschiedenen Abschnitten geradlinig verlaufen. Relativ zu den beiden Isolierlagen verlaufen die Leiter stets zueinander parallel und geradlinig.

Alternativ besteht auch die Möglichkeit, die Leiter zunächst auf die eine Isolierlage aufzulegen und ggf. gemäß einem gewünschten, ggf. gebogenem Verlauf anzuordnen und erst anschließend die andere Isolierlage aufzulaminieren, so dass der Laminatverbund ausgebildet ist.

In bevorzugter Ausgestaltung handelt sich bei den Leitern um massive, insbesondere blanke Rundleiter, also um Leiter mit einem kreisrunden Querschnitt. Bei der Verwendung von Rundleitern anstelle von beispielsweise flach gewalzten Leitern lässt sich insgesamt eine höhere Prozessgeschwindigkeit erzielen, da auf ein Flachwalzen der im Ausgangszustand typischerweise runden Leiter verzichtet ist und das Flachwalzen die Prozessgeschwindigkeit limitiert.

In bevorzugter Weiterbildung sind zumindest zwei Leiter über eine Querkontaktierung elektrisch miteinander verbunden. Die Einbringung derartiger Querkontaktierungen und der damit einhergehenden elektrischen Verbindung von zwei Leitern ermöglicht es, das elektrische Potenzial des einen Leiters auf den anderen Leiter zu übertragen. Hierdurch können beispielsweise Abzweigleitungen vorbereitet werden. In einer Variante wird jeweils ein Leiter mit genau einem weiteren Leiter verbunden. Alternativ hierzu wird ein Leiter mit mehreren, beispielsweise zwei Leitern verbunden. Hierdurch ist also eine Art Aufsplicen eines Leiters auf mehrere Leiter möglich. Speziell kann hierdurch das Potenzial des einen Leiters, welcher beispielsweise auf Pluspotenzial liegt und mit einer Strom- oder Spannungsquelle verbunden ist, auf mehrere Leiter übertragen werden. Auch kann hierdurch ein Datensignal auf mehrere Leiter übertragen werden.

Die Querkontaktierung wird dabei außen auf eine der beiden Isolierlagen und damit auf den Laminatverbund aufgebracht. Dies erfolgt in einem dem Laminierprozess nachfolgenden Prozessschritt.

Die Querkontaktierung erstreckt sich dabei insbesondere lediglich über eine begrenzte Breite, so dass allenfalls ein Teil der parallel geführten Leiter überbrückt ist. Die Querkontaktierung erstreckt sich maximal über die Breite des Laminatverbundes.

In bevorzugter Ausgestaltung wird zur Ausbildung der Querkontaktierung in zumindest einer der Isolierlagen und vorzugsweise lediglich in einer der Isolierlagen zumindest ein Fenster eingebracht, sodass die beiden zu verbindenden Leiter im Bereich des zumindest einen Fensters von der Isolierung befreit sind. Gemäß einer ersten Variante wird für jeden Leiter individuell ein Fenster vorgesehen und gemäß einer zweiten Variante wird ein gemeinsames Fenster oder mehrere gemeinsame Fenster eingebracht, welche(s) mehrere Leiter überdeckt. Die beiden Leiter sind über einen Querleiter elektrisch miteinander verbunden. Der Querleiter, beispielsweise ein Draht, wird auf die durch den Laminatverbund gebildete Flachleitung aufgelegt und mit den beiden zu verbindenden Leitern elektrisch leitend verbunden. Die elektrisch leitende Verbindung zwischen dem Querleiter und den Leitern kann dabei in an sich bekannter Weise erfolgen, z.B. durch Löten, Schweißen oder durch ein aus der Leiterplatten-Technologie bekanntes Bonding-Verfahren wie z.B. das sogenannte Dickdraht-Bonden. Die Querkontaktierung stellt allgemein eine Verbindungsbrücke zwischen den beiden Leiter dar.

In zweckdienlicher Weiterbildung wird dieser Querleiter, zumindest die Kontaktstellen zu den beiden Leitern, elektrisch isoliert. Hierzu wird Isoliermaterial in einem zusätzlichen Fertigungsschritt aufgebracht. Dies kann beispielsweise durch Aufsprühen, Streichen oder auch durch Aufkleben eines Isolierbands erfolgen. Auch besteht die Möglichkeit, dass eine weitere Isolierlage auflaminiert wird. Bevorzugt wird das Isoliermaterial jedoch lediglich im Bereich der Querkontaktierung aufgebracht.

In bevorzugter Ausgestaltung werden allgemein ein oder mehrere Fenster zumindest in einer der Isolierlagen eingebracht, um an dieser Stelle ein oder auch mehrere Leiter freizulegen. Hierdurch besteht allgemein die Möglichkeit der Kontaktierung der Leiter, um diese nicht nur untereinander, sondern ggf. auch mit weiteren Komponenten zu verbinden.

In bevorzugter Ausgestaltung ist im Bereich des zumindest einen Fensters ein elektrisches oder elektronisches Bauteil aufgebracht und mit ein oder mehreren der Leiter elektrisch leitend verbunden. Bei dem Bauteil handelt es sich beispielsweise um ein Leuchtelement, wie z.B. eine LED. Alternativ handelt es sich um einen Widerstand, eine Diode oder ein sonstiges Bauteil. Alternativ oder ergänzend ist bevorzugt auch ein komplexes Bauteil wie z.B. eine (klein-) Elektronik, wie z.B. eine Leiterplatte mit darauf angebrachter Elektronik mit der Flachleitung verbunden. Beispielsweise kann dadurch der Kabelsatz eine gewisse Intelligenz aufweisen und beispielsweise zur Auswertung von Daten oder auch als Steuerbauteil ausgebildet sein.

Die Bauteile sind dabei beispielsweise mechanisch an der Isolierung beispielsweise über Kleben fixiert. Die elektrische Verbindung mit den Leitern erfolgt - wie auch bei der Querkontaktierung - beispielsweise über Löten, Schweißen oder ein aus der Leiterplatten-Technologie bekanntes Bonding-Verfahren. Durch diese Maßnahme entfällt z.B. die Notwendigkeit einer Steckverbindung zu solchen Bauteilen.

In zweckdienlicher Ausgestaltung weist die Flachleitung einen Hauptstrang sowie zumindest einen Nebenstrang jeweils mit mehreren Leitern auf. Der Hauptstrang und der zumindest eine Nebenstrang bilden zumindest zu Beginn des Laminierprozesses die Flachleitung aus und sind in einer gemeinsamen Ebene angeordnet. Zur Ausbildung einer Abzweigleitung wird die Isolierung der Flachleitung über ein begrenztes axiales Teilstück mit einer Perforation versehen oder eingeschnitten. Der fertig ausgebildete Kabelsatz selbst ist dann über das axiale Teilstück eingeschnitten, sodass also der Nebenstrang von dem Hauptstrang über das axiale Teilstück getrennt ist, jedoch gleichzeitig über ein gemeinsames Verbindungsstück noch mit dem Hauptstrang über die Isolierung verbunden ist. Durch Umknicken des bandförmigen Nebenstrangs kann dieser dann in einem beliebigen Winkel, speziell einem 90° Winkel zum Hauptstrang als Abzweigleitung weggeführt werden.

Vorzugsweise ist zumindest ein Leiter des Nebenstrangs, vorzugsweise zumindest zwei oder alle Leiter des Nebenstrangs jeweils mit einem zugeordneten Leiter des Hauptstrangs über die zuvor beschriebene Querkontaktierung elektrisch leitend verbunden. Dadurch wird also das Potenzial des jeweiligen Leiters des Hauptstrangs auf den jeweiligen Leiter des Nebenstrangs übertragen.

Im endkonfektionierten Zustand ist das eine Ende des Nebenstrangs elektrisch vorzugweise lediglich über derartige Querkontaktierungen mit dem Hauptstrang verbunden. Dieser ist beispielsweise mit seinem einen Ende mit einer elektrischen Komponente, beispielsweise mit einer Strom- oder Spannungsquelle verbunden. Der Nebenstrang ist daher (lediglich) mittelbar über den Hauptstrang mit dieser elektrischen Komponente verbunden.

Zur Ausbildung des Nebenstrangs ist vorzugsweise der zumindest eine Leiter, welcher mit dem Hauptstrang elektrisch leitend verbunden ist, in Längsrichtung der Flachleitung mechanisch unterbrochen, wodurch quasi das eine Ende des Nebenstrangs ausgebildet ist. Bevorzugt ist der Nebenstrang durch eine quer verlaufende Unterbrechung abgetrennt, so dass ein Ende des Nebenstrangs ausgebildet ist. Der axiale Abstand zwischen der Unterbrechung und der Perforation bzw. des axialen Einschnitts definiert die axiale Ausdehnung des Verbindungsstücks.

In bevorzugter Ausgestaltung sind mehrere Nebenstränge vorgesehen, welche sich in Längsrichtung der Flachleitung aneinander anschließen, wobei die Leiter der beiden Nebenstränge voneinander durch eine Unterbrechung getrennt sind, sodass die Leiter der Nebenstränge elektrisch nicht miteinander verbunden sind. Jeder der Leiterstränge ist vorzugsweise individuell über Querkontaktierungen mit dem Hauptstrang verbunden.

Zur Ausbildung der Unterbrechung wird die Flachleitung beispielsweise von einer Randseite her in Querrichtung senkrecht zur Längsrichtung eingeschnitten. Bevorzugt wird ein Teilstück, welches auch eine Ausdehnung in Längsrichtung aufweist, aus der Flachleitung beispielsweise durch Stanzen herausgetrennt, sodass eine zuverlässige Trennung erreicht ist.

Die Flachleitung weist bevorzugt seitliche Randstreifen sowie bei Bedarf weiterhin ein oder mehrere Mittenstreifen auf, welche frei von Leitern sind, bei denen also ausschließlich Isoliermaterial vorliegt. Im Bereich dieser sich in Längsrichtung der Flachleitung erstreckenden Isolierstreifen sind in bevorzugter Ausgestaltung Befestigungspunkte zur Befestigung an einem Trägerbauteil ausgebildet. Der Kabelsatz und speziell die Flachleitung weist daher bereits vorbereitete Befestigungspunkte auf.

Bei diesen Befestigungspunkten handelt sich gemäß einer ersten Ausführungsvariante beispielsweise um Löcher in der Isolierung, die insbesondere durch einen Stanzvorgang ausgebildet sind. Mithilfe dieser Löcher erfolgt die Befestigung am Trägerbauteil beispielsweise mittels Befestigungszapfen.

In einer bevorzugten Alternative hierzu ist die Flachleitung mit dem Trägerbauteil stoffschlüssig befestigt, beispielsweise durch Kleben und vorzugsweise durch ein Verschweißen mit dem Trägerbauteil. Alternativ oder ergänzend sind der Laminatverbund und das Trägerbauteil auch miteinander verprägt, insbesondere durch ein Heißprägeverfahren.

In bevorzugter Ausbildung besteht die Isolierung hierzu aus einem schweißfähigen Material, insbesondere aus einem Polypropylen. Grundsätzlich können jedoch auch andere Materialien verwendet werden, welche schweißfähig sind. Zum Verschweißen wird vorzugsweise ein Laserschweißen oder auch ein herkömmliches thermischen Schweißen herangezogen, bei dem beispielsweise durch einen beheizbaren Schweißstempel die Materialien erwärmt und teilweise aufgeschmolzen werden. Alternativ besteht auch die Möglichkeit eines Ultraschallschweißen. Weiterhin ist ein sogenanntes Heißverprägen vorgesehen, bei dem beim stoffschlüssigen Verschweißen zugleich auch ein Umformen (Prägen) erfolgt. Dies ist insbesondere beim zuvor genannten thermischen Schweißen vorgesehen.

Das Trägerbauteil besteht vorzugsweise aus dem gleichen Material wie die Isolierlagen, insbesondere aus einem thermoplastischen Kunststoff und speziell aus PP.

Beim Trägerbauteil handelt es sich typischerweise um ein hartes Kunststoffbauteil. Alternativ hierzu ist es in bevorzugter Ausgestaltung als ein weiches, nachgiebiges Bauteil, insbesondere als ein geschäumtes Bauteil und / oder als ein Vlies ausgebildet. Bei diesem Bauteil handelt es sich beispielsweise um ein akustisches oder thermisches Dämm-Bauteil, auf das der Laminatverbund unmittelbar aufgebracht ist.

Im endgefertigten Zustand ist der Kabelsatz allgemein am Trägerbauteil, speziell einem Kraftfahrzeug-Bauteil befestigt, und zwar insbesondere durch Schweißen.

Das Kraftfahrzeug-Bauteil ist insbesondere ausgewählt aus einer Türinnenverkleidung, einem Klimakasten, einem Stoßfänger, einem Cockpit, einem inneren Verkleidungsteil, einem Kabelkanal, einer Heckklappe oder einem Gehäuse oder Träger einer als Backbone bezeichneten Hauptversorgungsleitung. Der Laminatverbund ist daher unmittelbar auf einem solchen Bauteil stoffschlüssig insbesondere durch Schweißen befestigt.

Bevorzug ist ausschließlich eine stoffschlüssige Befestigung vorgesehen und auf weitere Befestigungen, z.B. über mechanische Befestigungselemente wie Clipse oder Schrauben, Nieten usw., ist verzichtet.

Der Laminatverbund ist im Ausgangszustand typischerweise als ein flaches und damit zweidimensionales Bauteil ausgebildet. Hierunter wird verstanden, dass sich der gesamte Laminatverbund lediglich innerhalb einer Ebene erstreckt.

Das Kfz-Bauteil ist demgegenüber typischerweise nicht flach ausgebildet, weist also eine dreidimensionale Oberflächenstruktur auf. Hierunter wird verstanden, dass die Oberfläche, auf der der Laminatverbund aufgebracht ist, nicht innerhalb einer Ebene angeordnet ist. Bei der Montage schmiegt sich daher der Laminatverbund der 3D-Oberflächenkontur des Kfz-Bauteils an.

In bevorzugter Ausgestaltung ist auf eine Oberfläche des Laminatverbundes eine Vermittlerschicht aufgebracht. Über diese Vermittlerschicht erfolgt die stoffschlüssige Verbindung mit dem Trägerbauteil. Über die Vermittlerschicht wird eine gute Haftung auch dann ermöglicht, wenn der Laminatverbund und das Trägerbauteil aus unterschiedlichen Materialien bestehen. Bei der Vermittlerschicht handelt es sich beispielsweise um eine ggf. durch Wärme aktivierbare Kleberschicht und / oder einem sogenannten Heißsiegellack usw.

Zum Verbinden des Laminatverbundes mit dem Trägerbauteil ist gemäß einer bevorzugten Ausgestaltung ein Prägeverfahren, insbesondere ein Heißprägeverfahren vorgesehen. Bei diesem erfolgt typischerweise eine Verformung der Oberfläche des Laminatverbundes sowie korrespondierend auch der Oberfläche des Trägerbauteils, so dass die Oberflächen ineinandergreifen und insbesondere quasi miteinander verzahnt werden. Die in die Oberfläche beim Prägen eingebrachten Erhebungen / Vertiefungen weisen typischerweise eine Höhe im mm-Bereich (0,5 mm bis 3 mm) oder auch mehr auf. Mit einem solchen Prägeverfahren können insbesondere auch unterschiedliche Materialien miteinander zuverlässig verbunden werden. Speziell besteht das Trägerbauteil aus einem Metall. Ein derartiges Verprägen zwischen unterschiedlichen Materialien ist beispielsweise bei Lebensmittelverpackungen (z.B. Al-Deckel auf einem Kunststoff-Becher) bekannt.

Für ein derartiges (Heiß-) Prägen wird insbesondere die zuvor beschriebene Vermittlerschicht herangezogen.

Endseitig an der Flachleitung, zumindest an einem Ende der Flachleitung ist vorzugsweise zumindest ein Kontaktstecker angeordnet, über den die elektrische Verbindung mit einer elektrischen Komponente wie beispielsweise eine Versorgungsquelle oder auch mit einem elektrischen Verbraucher erfolgt. Der Kontaktstecker ist hierzu sowohl mechanisch als auch elektrisch mit der Flachleitung verbunden. Die mechanische Verbindung erfolgt hierbei vorzugsweise über die Isolierung. Beispielsweise greift der Kontaktstecker hierzu in die vorbereiteten Löcher ein.

Die Aufgabe wird im Hinblick auf das Verfahren weiterhin gelöst durch ein Verfahren zur Herstellung eines solchen Kabelsatzes, bei dem die Leiter in einem Laminierprozess parallel zwischen zwei Isolierlagen zugeführt werden und die Isolierlagen stoffschlüssig miteinander verbunden werden und die Isolierung ausbilden.

Die im Zusammenhang mit dem Kabelsatz angeführten Vorteile und bevorzugten Ausgestaltungen sind sinngemäß auch auf das Verfahren zu übertragen und umgekehrt.

Bevorzugt werden Freimachungen in die Isolierung eingebracht, und zwar als Fenster in den Bereichen der Leiter und/oder als Befestigungspunkte in Bereichen ohne Leiter. Darüber hinaus werden Freimachungen alternativ oder ergänzend auch als Unterbrechungen zum Trennen der Leiter von Nebensträngen eingebracht. Bei der Ausbildung der Unterbrechungen wird neben der Isolierung auch der Leiter durchtrennt.

Die Freimachungen werden dabei vorzugsweise durch Stanzen oder auch durch eine Laserbearbeitung ausgebildet.

Zumindest ein Teil der Freimachungen und vorzugsweise alle Freimachungen (bis auf die Unterbrechungen) werden vorzugsweise eingebracht, bevor die Leiter zugeführt werden. Die Freimachungen werden daher vor dem eigentlichen Laminierprozess in zumindest einer Isolierlage oder auch in beiden Isolierlagen eingebracht. Speziell bei der Ausbildung der Fenster ist dies von besonderem Vorteil, da eine Beschädigung der Leiter bei der Ausbildung der Freimachungen hierdurch zuverlässig vermieden ist. Die Freimachungen (Fenster) werden daher an vorab definierten, festen Positionen eingebracht.

Bevorzugt wird in die Isolierung über ein axiales Teilstück ein Längsschnitt oder eine Längsperforation zur Abtrennung eines Nebenstrangs eingebracht, beispielsweise mechanisch und vorzugsweise durch eine Laserbehandlung.

Der Kabelstrang wird weiterhin auf ein Trägerbauteil, speziell ein Bauteil eines Kraftfahrzeugs aufgebracht, und zwar vorzugsweise stoffschlüssig und speziell durch Schweißen.

Das Verfahren zur Ausbildung des Kabelsatzes erfolgt vorzugsweise in einem Inline-Herstellungsprozess, bei dem zusätzlich zu dem eigentlichen Laminierprozess eine und vorzugsweise mehrere zusätzliche Fertigungsschritte innerhalb einer Fertigungslinie erfolgen. Unter Inline- Herstellungsprozess wird vorliegend allgemein ein kontinuierlich durchgehender Herstellungsprozess verstanden, bei dem innerhalb einer Fertigungslinie mit mehreren aufeinander folgenden Fertigungsstationen mehrere einzelne Fertigungsschritte in einem kontinuierlichen Verfahren unmittelbar aufeinanderfolgend durchgeführt werden.

Bei dem Laminierprozess wird zunächst ein Endlos-Zwischenprodukt bereitgestellt, welches im Laufe des Inline-Herstellungsprozesses durch die weiteren Fertigungsschritte weiter konfiguriert wird.

Aus dem Endlos-Zwischenprodukt werden dann einzelne Kabelsätze mit vorgegebener Länge abgetrennt. Bevorzugt handelt es sich bei den Kabelsätzen um identische Kabelsätze. Alternativ werden im Rahmen des Inline-Herstellungsprozesses unterschiedliche Kabelsätze ausgebildet, die jedoch bevorzugt auf dem gleichen Laminierprozess aufbauen.

Im Rahmen des Inline-Herstellungsprozesses werden neben dem Laminierprozess vorzugsweise mehrere Fertigungsschritte ausgeführt. Zu diesen Fertigungsschritten gehören insbesondere die Einbringung von Freimachungen, die Ausbildung von Querverbindungen, das Einbringen einer Perforation oder eines Schnittes über einen axialen Teilabschnitt zur Trennung eines Nebenstrangs von einem Hauptstrang sowie bei Bedarf auch die Befestigung und Kontaktierung eines Kontaktsteckers an der Flachleitung. Bevorzugt werden alle diese Fertigungsschritte innerhalb des Inline-Herstellungsprozesses ausgeführt.

In zweckdienlicher Ausgestaltung erfolgt weiterhin im Rahmen des Inline-Herstellungsprozesses auch die Befestigung des vorkonfigurierten Kabelsatzes an einem Trägerbauteil, speziell mittels Schweißen. Bei dem Trägerbauteil handelt es sich beispielsweise um ein Bauteil, welches bei einer Endmontage des Kraftfahrzeugs an einem weiteren Bauteil befestigt wird. Beispielsweise handelt sich bei dem Trägerbauteil um ein Verkleidungselement, beispielsweise eine Türverkleidung, einen Armaturenträger, eine Mittelkonsole usw. Am Ende der Fertigungslinie wird daher ein für die Endmontage vorkonfiguriertes Kraftfahrzeug-Bauteil mit einem daran befestigten Kabelsatz bereitgestellt.

Ein Ausführungsbeispiel der Erfindung wird nachfolgend anhand der Figuren näher erläutert. Diese zeigen in vereinfachten Darstellungen:
- FIG 1: eine Darstellung zur Erläuterung des Laminierprozesses,
- FIG 2: eine Aufsicht auf ein Zwischenprodukt mit vorbereiteten Befestigungspunkten bei der Herstellung eines Kabelsatzes,
- FIG 3: eine Aufsicht auf ein weitergehendes Zwischenprodukt mit vorbereiteten Nebensträngen bei der Herstellung eines Kabelsatzes sowie
- FIG 4: eine Aufsicht auf einen endgefertigten Kabelsatz.

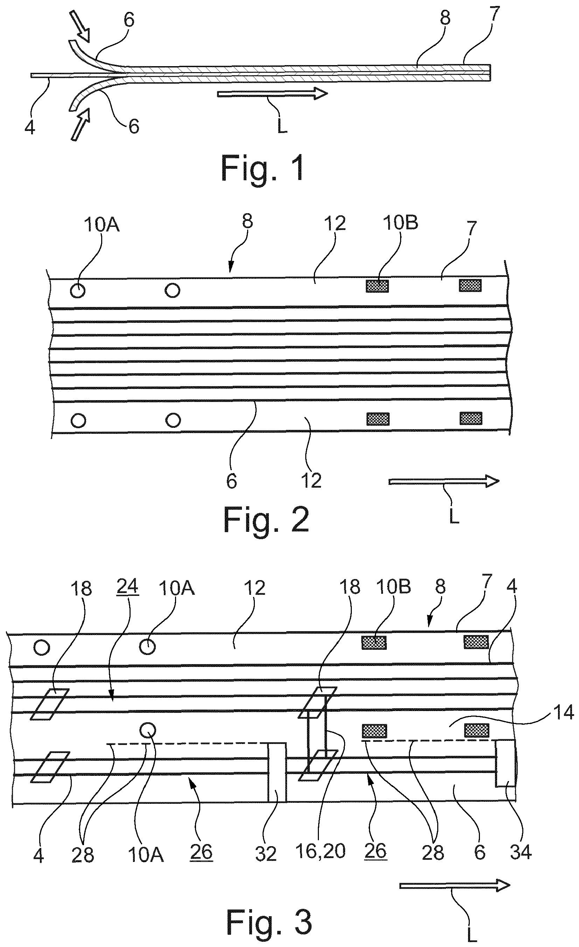

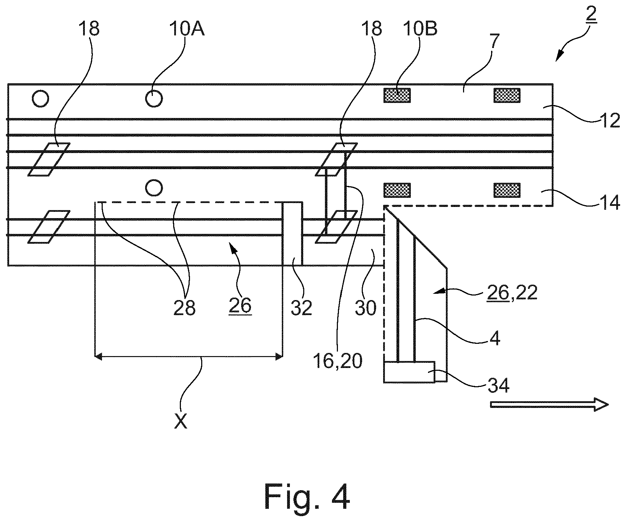

Zur Herstellung eines Kabelsatzes 2, wie er in der FIG 4 dargestellt ist, wird ein Laminierprozess eingesetzt. Dieser ist schematisch in FIG 1 illustriert:
Mehrere, parallel nebeneinander geführte Leiter 4 werden zwischen zwei Isolierlagen 6 einlaminiert so dass ein Laminatverbund 7 ausgebildet wird. Die Leiter 4 sind hierbei als blanke Leiter 4, also ohne einem Isoliermantel ausgebildet. Hierzu werden die beiden Isolierlagen 6 von oben und unten in Richtung zu den Leitern 4 geführt und miteinander stoffschlüssig verbunden. Dabei wird durch den Laminatverbund 7 eine Flachleitung 8 ausgebildet. Als Leiter 6 werden massive Rundleiter eingesetzt. Hierdurch weisen die Leiter 6 - beispielsweise im Vergleich zu Litzenleitern - nur einen geringen Außendurchmesser auf. Zudem ist dadurch die Biegesteifigkeit ausreichend für den vorgesehenen automatisierten Herstellungs- und insbesondere Montageprozess.

Die beiden miteinander verbundenen Isolierlagen 4 bilden eine Isolierung der Flachleitung 8. Bei dem Laminierprozess handelt sich um einen Endlos-Prozess, bei dem die Isolierlagen 6 sowie die Leiter 4 von einem Vorrat, beispielsweise von Vorratsspulen zugeführt werden. Der Laminierprozess erfolgt dabei in einer Längsrichtung L, die zugleich einer Längsrichtung L des auszubildenden Kabelsatzes 2 entspricht.

Die FIG 2 zeigt als eine Zwischenstufe ein Zwischenprodukt im Rahmen des Herstellungsverfahrens. Im vorliegenden Fall handelt es sich um die Flachleitung 8, bei der bereits Befestigungspunkte 10A, 10B ausgebildet sind. Bei diesen handelt es sich um ausgestanzte Löcher 10A und / oder um beispielsweise für ein stoffschlüssiges Verbinden vorgesehene Bereiche 10B. Bei Bedarf sind diese Bereiche 10B für die stoffschlüssige Verbindung speziell vorbereitet. Die stoffschlüssige Verbindung erfolgt beispielsweise über ein Verkleben oder auch über ein Verschweißen. Speziell für den Fall, dass eine stoffschlüssige Verbindung vorgesehen ist, kann es sich bei den Befestigungspunkten 10B auch um eine durchgehende Befestigungslinie handeln. Bei einer stoffschlüssigen Befestigung z.B. durch Schweißen kann bei einer geeigneten Materialwahl für die Isolierlagen 6 auch grundsätzlich auf eine spezielle Vorbereitung verzichtet werden. Im Endzustand, wenn der Kabelsatz an einem Trägerbauteil befestigt ist, ist der Kabelsatz an den Befestigungspunkten 10A, 10B am Trägerbauteil fixiert.

Die Befestigungspunkte 10A, 10B sind im Ausführungsbeispiel der FIG 2 in gegenüberliegenden Randstreifen 12 ausgebildet, die die Flachleitung 8 randseitig begrenzen und in denen keine Leiter 4 verlaufen. Im Ausführungsbeispiel der FIG 3 ist noch ein Mittenstreifen 14 frei von Leitern 6 ausgebildet, in dem ebenfalls Befestigungspunkte 10A, 10B ausgebildet sind.

Die Befestigungspunkte 10A, 10B werden wahlweise bereits vor dem in FIG 1 dargestellten Laminierprozess oder auch nach diesem in die Isolierlagen 6 eingebracht. Bevorzugt werden sie nach dem Laminierprozess eingebracht. Bei dem in der FIG 2 dargestellten Zwischenprodukt handelt sich weiterhin um eine Endlos-Ware.

In zusätzlichen Fertigungsschritten werden Querkontaktierungen 16 eingebracht. Hierzu werden zunächst Fenster 18 in eine der beiden Isolierlagen 6 eingebracht. Das Einbringen der Fenster 18 erfolgt vorzugsweise vor dem Laminierprozess beispielsweise durch Stanzen oder auch durch (Laser) Schneiden. Alternativ werden die Fenster 18 nach dem Laminierprozess ausgebildet. Dies ist jedoch prozesstechnisch etwas aufwendiger, um ein Verletzen der Leiter 6 zu vermeiden.

Anschließend werden zwei Leiter 6, die elektrisch miteinander verbunden werden sollen, mittels einer elektrischen Brücke, speziell mittels eines Querleiters 20 verbunden. Bei diesem handelt es sich beispielsweise um einen Draht. Dieser Querleiter 20 wird insbesondere stoffschlüssig mit dem jeweiligen Leiter 6 verbunden. Die beiden miteinander verbundenen Leiter 6 liegen damit im Betrieb auf einem gleichen Spannungspotenzial.

Die Querverbindungen 16 werden insbesondere zur Ausbildung von Abzweigleitungen 22 (vgl. hierzu FIG 4) ausgebildet, sodass also die Leiter 6 einer Abzweigleitung 22 elektrisch kontaktiert sind.

Zur Erzeugung der Abzweigleitung 22 wird die Flachleitung 8 unterteilt in einen Hauptstrang 24 sowie in einen Nebenstrang 26 und vorzugsweise in mehrere Nebenstränge 26, die seitlich neben dem Hauptstrang 24 verlaufen. Im Ausführungsbeispiel der FIG 3 und FIG 4 schließen sich mehrere Nebenstränge 26 in Längsrichtung L aneinander an.

Zur Ausbildung der Nebenstränge 26 wird in einem Fertigungsschritt über eine axiale Teillänge X eine Perforation 28 oder auch ein Längsschnitt eingebracht. Entlang dieser so ausgebildeten axialen Trennstelle wird in einem späteren Fertigungsschritt der Nebenstrang 26 vom Hauptstrang 8 über die axiale Teillänge X abgetrennt und beispielsweise durch Umknicken seitlich weggeführt.

Ein jeweiliger Nebenstrang 26 bleibt gleichzeitig über ein Verbindungsstück 30 mit dem Hauptstrang 24 verbunden. Innerhalb dieses Verbindungsstücks 30 sind die Querkontaktierungen 16 ausgebildet.

Mehrere Nebenstränge 26 sind in Längsrichtung L bei der Endlos-Flachleitung 8 aufeinanderfolgend hintereinander ausgebildet. Weist ein Kabelsatz 2 an einer Seite der Flachleitung 8 mehrere solcher Nebenstränge 26 zur Ausbildung von mehreren Abzweigleitungen 22 auf, wie dies im Ausführungsbeispiel dargestellt ist, so sind diese in Längsrichtung L mechanisch und elektrisch voneinander getrennt. Hierzu ist eine Unterbrechung 32 insbesondere in Form einer Ausstanzung eingebracht. Diese erstreckt sich über die gesamte Breite des Nebenstrangs 26 senkrecht zur Längsrichtung L und damit in Querrichtung.

Grundsätzlich können an beiden Randseiten der Flachleitung 8 Nebenstränge 26 ausgebildet sein.

Im fertigen Kabelsatz 2 erstreckt sich die axiale Teillänge X ausgehend von einer Stirnseite des Kabelsatzes 2 oder ausgehend von einer Unterbrechung 32 bis zu einem Verbindungsstück 30.

Bevorzugt wird in einem weiteren Fertigungsschritt ein Kontaktstecker 34 an der Flachleitung 8 an einem vorgesehenen Ende des Kabelsatzes 2 angebracht. Bevorzugt wird an einem jeweiligen Ende eines jeweiligen Nebenstrangs 26 jeweils ein solcher Kontaktstecker 34 angebracht. Weiterhin wird vorzugsweise ein Kontaktstecker 34 auch an einem oder an beiden Enden des Hauptstrangs 24 angebracht. Der Kontaktstecker 34 ist mechanisch an der Flachleitung 8 befestigt und kontaktiert die einzelnen Leiter 6 in geeigneter Weise. Der Kontaktstecker 34 wiederum weist entweder Buchsenkontakte oder Steckkontakte für eine Steckkontaktierung auf.

Zur elektrischen Kontaktierung der Leiter 6 wird beispielsweise eine an sich bekannte Schneid -Klemmkontaktierung verwendet. Hierzu wird der Kontaktstecker 34, zumindest dessen Kontaktteile auf die Flachleitung 6 aufgepresst. Die mechanische Verbindung erfolgt über die Isolierung, sodass über diese auch die Zugkräfte aufgenommen werden. Dadurch können auch extrem dünne Leiter 6 eingesetzt werden, da diese keiner, bzw. geringer Zugbeanspruchung ausgesetzt sind.

Die einzelnen hier beschriebenen Fertigungsschritte erfolgen vorzugsweise innerhalb eines Inline-Herstellungsprozesses, bei dem also innerhalb einer Fertigungslinie die einzelnen Fertigungsschritte aufeinanderfolgend ausgeführt werden. Im Rahmen dieses Inline-Fertigungsprozesses erfolgt zudem ein Ablängen der Endlos-Flachleitung 8 auf die gewünschte Länge des auszubildenden Kabelsatzes 2. Dieses Ablängen erfolgt beispielsweise als letzter Fertigungsschritt. Alternativ kann es sich bei dem Ablängen auch um einen Zwischenschritt handeln, sodass die abgelängten Zwischenprodukte nachfolgend noch endkonfiguriert werden.

In einer weiteren, in den Figuren nicht näher dargestellten bevorzugten Ausgestaltung wird innerhalb der Fertigungslinie der Kabelsatz 2 weiterhin noch auf ein Trägerbauteil, speziell ein Kraftfahrzeug-Bauteil aufgebracht. Hierzu erfolgt die Befestigung am Trägerbauteil beispielsweise mithilfe der Befestigungspunkte 10A, 10B. Bevorzug erfolgt die Befestigung jedoch insbesondere ausschließlich stoffschlüssig über ein Verschweißen. Bei dem Trägerbauteil handelt sich insbesondere um ein Kunststoff-Trägerbauteil. Das Material der Isolierlagen 6 ist geeignet gewählt, um eine Schweißverbindung mit dem Kunststoff-Trägerbauteil zu ermöglichen. Als Material für die Isolierlagen 6 wird insbesondere Polypropylen herangezogen. Da im Kraftfahrzeug die meisten Kunststoffbauteile aus Polypropylen bestehen, ist ein stoffschlüssiges Verbinden, insbesondere ein Verschweißen des Kabelsatzes 2 mit dem Trägerbauteil besonders einfach. Hierzu wird das Material der Isolierung direkt mit dem Material des Trägerbauteils durch einen Wärmeeintrag verschweißt.

Insgesamt ist durch den hier beschriebenen Prozess zur Ausbildung eines Kabelsatzes 2 eine kostengünstige und einfache sowie prozesssichere Herstellung eines insbesondere auch verzweigten Kabelsatzes 2 ermöglicht. Hervorzuheben ist, dass der Herstellungsprozess des Kabelsatzes 2 vollautomatisiert erfolgen kann und insbesondere auch erfolgt, d. h. die einzelnen hier beschriebenen Fertigungsschritte erfolgen vollautomatisch ohne manuelle Eingriffe. Durch die Verwendung von unisoliertem Leiter-Vollmaterial als Ausgangsprodukt wird auf ein Standardprodukt zurückgegriffen und weiterhin werden unnötige Prozessschritte, wie z.B. das Ziehen und Verlitzen von Einzeldrähten sowie ein Prozess zur Isolation von Einzeldrähten vermieden. Hierdurch werden die notwendige Energie im Herstellungsprozess und die Vielfalt der eingesetzten Materialien reduziert und somit die Nachhaltigkeit gefördert.

Am Ende der Fertigungslinie liegt daher der endkonfigurierte Kabelsatz 2 oder sogar das Trägerbauteil mit dem daran befestigten Kabelsatz 2 vor. Das hier beschriebene Verfahren und der beschriebene Kabelsatz 2 zeichnet sich insbesondere durch folgende Vorteile aus:
- eine kostengünstige Fertigung durch die Kombination von massiven Rundleitern (Entfall eines Verseilprozesses im Vergleich zu Litzenleitern, Entfall eines Walzschrittes) und einem Laminierprozess (Entfall eines Extrusionsschrittes),
- Nutzung eines seitlichen Randstreifens 12 der Isolierlagen 6 zur Vorbereitung einer Befestigung und beispielsweise zur Integration von Befestigungselementen und / oder für die bevorzugte Schweißverbindung,
- wahlweise Erzeugung einer Endlos-Ware (sogenannte Meterware) oder auch von identischer oder auch unterschiedlicher Stückware (individuelle Kabelsätze 2),
- Einstellen eines erforderlichen Rasters oder auch Querabstands zwischen den einzelnen Leitern 6, beispielsweise um den Mittenstreifen 14 zur Einbringung der Perforation 28 auszubilden,
- Fixierung der Abzweigleitung 22 über die Perforation 28 bis zur endgültigen Montage bzw. bis zur elektrischen Verbindung mit einer Komponente am Montageort. Dieser Schritt des Abtrennen der Abzweigleitung 22 entlang der Perforation 28 erfolgt vorzugsweise ebenfalls automatisch. Bevorzugt erfolgt weiterhin auch die elektrische Verbindung mit einer jeweiligen Komponente automatisch, speziell über den Kontaktstecker 34.

Unabhängig von der Inline-Fertigung ist der Laminatverbund 7 auf einem Kraftfahrzeug-Trägerbauteil stoffschlüssig aufgebracht.

Dieses Befestigungskonzept sieht daher eine direkte Befestigung des Laminatverbundes 7 auf einem KFZ- Bauteil, insbesondere auf einem Karosseriebauteil vor. Dadurch ist eine unmittelbare Kombination von Kunststoff-Trägerbauteilen mit dem Laminatverbund 7 und damit mit den Leitern 4 erreicht. Der Laminatverbund 7 wird bevorzugt über ein geeignetes Schweißverfahren (z.B. Ultraschall, thermisches Schweißen, Heißverprägen,..) mit dem Trägermaterial verbunden. Auf die sonst üblichen mechanischen Befestigungselemente, insbesondere Clipse wird insbesondere verzichtet.

Die Schweißpunkte werden insbesondere vollautomatisiert bei der Endmontage des Folienleiters auf dem Träger (programmierbar) gesetzt, also insbesondere nachdem der Laminatverbund 7 auf das Kfz-Bauteil gelegt wurde. Der ursprünglich flache Laminatverbund 7 wird beim Schweißen von einer 2D Struktur (Zwischen- / Endprodukt der Kabelherstellung) in eine 3D Struktur überführt (Endmontage am Kraftfahrzeug). Das Bauteil besteht dabei insbesondere aus Polypropylen (PP), ggf. mit verschiedenen Beimischungen (z.B. Talkum, Glasfaser).

Mögliche Anwendungsbeispiele sind: Türinnenverkleidung, Klimakasten, Stoßfänger, Cockpit, Innere Verkleidungsteile, Kabelkanal, Backbone-Gehäuse/Träger, Heckklappe usw.

Ein direktes Schweißen auf einem Vlies (z.B. PP) oder Schaum (z.B. PP) ist ebenfalls möglich.

Um den Laminatverbund beispielsweise auch zuverlässig mit anderen Materialien zu verbinden kann er mit einer Vermittlerschicht, beispielsweise einseitig vollflächig oder auch partiell beschichtet werden / sein. Bei der Vermittlerschicht handelt es sich insbesondere um einen Heißsiegellack. Durch ein heißes Verstempeln / Verprägen wird der Flachleiter anschließend auf verschiedenste Oberflächen (z.B. auch auf metallische Oberflächen) aufgebracht (geklebt).

### Bezugszeichenliste

- 2: Kabelsatz
- 4: Leiter
- 6: Isolierlage
- 7: Laminatverbund
- 8: Flachleitung
- 10A: Löcher
- 10B: Bereich für stoffschlüssige Verbindung
- 12: Randstreifen
- 14: Mittenstreifen
- 16: Querkontaktierung
- 18: Fenster
- 20: Querleiter
- 22: Abzweigleitung
- 24: Hauptstrang
- 26: Nebenstrang
- 28: Perforation
- 30: Verbindungsstück
- 32: Unterbrechung
- 34: Kontaktstecker

- L: Längsrichtung
- X: axiale Teillänge

## Patentansprüche

1. Kabelsatz (2) zur elektrischen Verbindung von zumindest zwei Komponenten mit Hilfe einer Flachleitung (8), die mehrere von einer Isolierung umgebene Leiter (4) aufweist, **dadurch gekennzeichnet, dass** die Leiter (4) unmittelbar zwischen zwei Isolierlagen (6) einlaminiert sind und einen Laminatverbund (7) ausbilden.

2. Kabelsatz (2) nach dem vorhergehenden Anspruch, **dadurch gekennzeichnet, dass** es sich bei den Leitern (4) um massive Rundleiter handelt.

3. Kabelsatz (2) nach einem der vorhergehenden Ansprüche, **dadurch gekennzeichnet, dass** zumindest zwei Leiter (4) über eine Querkontaktierung (16) elektrisch miteinander verbunden sind, wobei die Querkontaktierung (16) auf dem Laminatverbund (7) von außen aufgebracht ist.

4. Kabelsatz (2) nach dem vorhergehenden Anspruch, **dadurch gekennzeichnet, dass** zur Ausbildung der Querkontaktierung (16) in zumindest eine der Isolierlagen (6) zumindest ein Fenster (18) eingebracht ist und ein Querleiter (20) mit den beiden Leitern (4) elektrisch verbunden ist.

5. Kabelsatz (2) nach einem der vorhergehenden Ansprüche, **dadurch gekennzeichnet, dass** die Flachleitung (8) einen Hauptstrang (24) mit mehreren Leitern (4) sowie einen Nebenstrang (26) mit mehreren Leitern (4) aufweist und dass zur Ausbildung einer Abzweigleitung (22) die Isolierung der Flachleitung (8) über ein axiales Teilstück eingeschnitten ist, so dass der Hauptstrang (24) vom Nebenstrang (26) getrennt ist, jedoch die beiden Stränge (24, 26) weiterhin über ein gemeinsames Verbindungsstück (30) miteinander verbunden sind.

6. Kabelsatz (2) nach einem der vorhergehenden Ansprüche, **dadurch gekennzeichnet, dass** in zumindest einer der Isolierlagen (6) ein Fenster (18) im Bereich zumindest eines der Leiter (4) ausgebildet ist und dass auf die Flachleitung (8) im Bereich der Fenster (18) ein elektrisches oder elektronisches Bauteil wie beispielsweise eine LED, ein Widerstand, eine Diode oder auch eine komplexes Bauteil wie z.B. eine Leiterplatte aufgebracht ist.

7. Kabelsatz (2) nach einem der beiden vorhergehenden Ansprüche, **dadurch gekennzeichnet, dass** zumindest zwei Nebenstränge (26) ausgebildet sind, welche in Längsrichtung (L) der Flachleitung (8) sich aneinander anschließen und die jeweils über ein Verbindungsstück (30) mit dem Hauptstrang (24) verbunden sind, wobei zumindest ein Teil der Leiter (4) der Nebenstränge (26) durch eine Unterbrechung (32) elektrisch voneinander getrennt sind, wobei zur Ausbildung der Unterbrechung (32) ein Bereich der Flachleitung (8) vorzugsweise entfernt ist.

8. Kabelsatz (2) nach einem der vorhergehenden Ansprüche, **dadurch gekennzeichnet, dass** die Isolierung aus einem schweißfähigen Material, insbesondere PP besteht.

9. Kabelsatz (2) nach einem der vorhergehenden Ansprüche, **dadurch gekennzeichnet, dass** er auf einem Kraftfahrzeug-Bauteil stoffschlüssig, insbesondere durch Schweißen befestigt ist, wobei das Kraftfahrzeug-Bauteil vorzugsweise aus dem gleichen Material wie die Isolierung, insbesondere aus PP besteht, wobei das Kraftfahrzeug-Bauteil bevorzugt ausgewählt ist aus einer Türinnenverkleidung, einem Klimakasten, einem Stoßfänger, einem Cockpit, einem inneren Verkleidungsteil, einem Kabelkanal, einer Heckklappe oder einem Gehäuse oder Träger einer als Backbone bezeichneten Hauptversorgungsleitung.

10. Kabelsatz (2) nach dem vorhergehenden Anspruch, **dadurch gekennzeichnet, dass** der im Ausgangszustand flache Laminatverbund (7) auf ein nicht flaches Kraftfahrzeug-Bauteil mit einer dreidimensionalen Oberflächenstruktur aufgebracht ist und an dessen dreidimensionaler Oberflächenstruktur befestigt ist,

11. Kabelsatz (2) nach einem der Ansprüche 8 bis 10, bei dem auf eine Oberfläche des Laminatverbundes (7) eine Vermittlerschicht aufgebracht ist, insbesondere eine Kleberschicht, Heißsiegellack usw., die für die Ausbildung einer stoffschlüssigen Verbindung geeignet ist.

12. Verfahren zur Herstellung eines Kabelsatzes (2) nach einem der vorhergehenden Ansprüche, welcher eine Flachleitung (8) mit mehreren von einer Isolierung umgebene Leiter (4) aufweist, wobei die mehreren Leiter (4) in einem Laminierprozess zwischen zwei Isolierlagen (6) laminiert werden und mit diesen einen Laminatverbund (7) ausbilden, derart, dass die Leiter (4) unmittelbar an den Isolierlagen anliegen und die Isolierlagen (6) stoffschlüssig miteinander verbunden werden.

13. Verfahren nach dem vorhergehenden Anspruch, bei dem Freimachungen in der Isolierung eingebracht werden und zwar wahlweise als Fenster (18) in den Bereichen der Leiter (4), als Befestigungspunkte (10A) in Bereichen ohne Leiter (4) oder zur Ausbildung von Unterbrechungen (32), bei denen Leiter (4) mechanisch getrennt werden, wobei in bevorzugter Ausgestaltung zumindest ein Teil der Freimachungen und vorzugsweise alle Freimachungen vor dem Laminierprozess eingebracht werden.

14. Verfahren nach einem der beiden vorhergehenden Ansprüche, bei dem im Rahmen eines Inline-Herstellungsprozesses innerhalb einer Fertigungslinie neben dem Laminierprozess zumindest einige und vorzugsweise alle der folgenden Fertigungsschritte ausgeführt werden:
- Einbringung von Freimachungen
- Ausbildung von Querkontaktierungen (16) zwischen zwei Leitern (4)
- Einbringen einer Perforation (28) oder eines Einschnittes über einen axialen Teilabschnitt (X) zur Trennung eines Nebenstrangs (26) von einem Hauptstrang (24)
- Befestigung und Kontaktierung eines Kontaktsteckers (34) an der Flachleitung (8),
- wobei vorzugsweise ergänzend innerhalb des Inline-Herstellungsprozesses der Kabelsatz (2) auf ein Trägerbauteil aufgebracht wird.

15. Verfahren nach einem der Anspruche 11 bis 14, bei dem der Laminatverbund (7) stoffschlüssig unmittelbar auf einem Kraftfahrzeug-Bauteil befestigt wird, insbesondere durch Schweißen oder Heißprägen.
